# EUROPEAN PATENT SPECIFICATION

(11) **EP 0 591 641 B1**
(45) Date of publication and mention of the grant of the patent: **16.04.1997**
(21) Application number: 93112517.3
(22) Date of filing: 04.08.1993
(51) Int. Cl.: H01L 39/24, H01L 39/22

(54) **DC superconducting quantum interference device**
Gleichstrom supraleitendes Quanteninterferenz-Bauelement
Dispositif supraconducteur à interférence quantique en courant continu

(30) Priority: 11.08.1992 JP 214246/92
(43) Date of publication of application: 13.04.1994
(73) Proprietor: SEIKO INSTRUMENTS INC., Tokyo (JP)
(72) Inventor: Shimizu, Nobuhiro, c/o Seiko Instruments Inc., Tokyo (JP); Chiba, Norio, c/o Seiko Instruments Inc., Tokyo (JP); Yabe, Satoru, c/o Seiko Instruments Inc., Tokyo (JP)
(74) Representative: Fleuchaus, Leo, Dipl.-Ing.

(56) References cited:
- EP-A- 0 063 887
- EP-A- 0 477 012
- EP-A- 0 501 220
- FUJITSU-SCIENTIFIC AND TECHNICAL JOURNAL, vol. 24, no. 1, 1988, Kawasaki, JP, pp. 47-52; S. OHARA et al.: "Reproducible Nb/A1Ox/Nb Josephson Junctions"
- PHYSICS TODAY, vol. 39, no. 3, March 1986, pp. 46-52; H. HAYAKAWA : "Josephson computer technology"
- PROCEEDINGS OF THE IEEE, vol. 70, no. 1, January 1982, pp. 26-34; T. GHEEWALA : "The Josephson Technology"

## Description

### Background of the invention

The present invention relates to a DC superconducting quantum interference device (which will be shortly referred to as "DC SQUID") according to the preamble of claim 1.

Such a DC SQUID is for example known from EP-A-0 477 012 and is for example applied to a highly sensitive magnetic sensor, e. g. an ammeter, a displacement meter, a highfrequency signal amplifier or the like.

The prior art DC SQUID according to EP-A-0 477 012, a schematic representation of which is shown in Fig. 2 in a top plan view, has a washer cover 8. Its operation was, however, unstable due to the lack of a ground plane, because interlinkage in external magnetic flux often occurred, which tended to invite trapping of magnetic flux.

Because the trapping of interlinkage in magnet flux is generated in the neighborhood of the Josephson device 1, the operation in the prior art DC SQUID became unstable.

Furthermore from Physics Today, Vol. 39, No. 3, March 1986, pages 46-52; H. Hayakawa: "Josephson Computer Technology" and from Proceedings of the IEEE, Vol. 70, No. 1, January 1982, pages 26-34; T. Gheewala: "The Josephson Technology" it is known to use a superconducting plane as the lowest ground plane of various superconducting devices. However, the latter two documents do not disclose or suggest how to actually design a DC SQUID in order to overcome the above-mentioned problem with respect to trapping of magenetic flux.

### Summary of the invention

It is an object of the present invention to provide a DC SQUID with stable operation.

In order to achieve the above-specified object, a ground plane of superconducting layer is provided in such a manner that the ground plane overlays the area that contains the Josephson device. For this production process, the number of processing steps does not have to be increased because this forming is simultaneously carried out with the same process in which the washer cover of the washer coil is processed.

Since the DC SQUID in the foresaid structure is superconductively shielded by a ground plane in the neighborhood of the Josephson device, interlinkage of external magnetic flux can be avoided, and stable operation can then be realized without trapping external magnetic flux.

### Brief description of the drawings

Fig. 1 is a top plan view showing a DC SQUID according to the present invention;

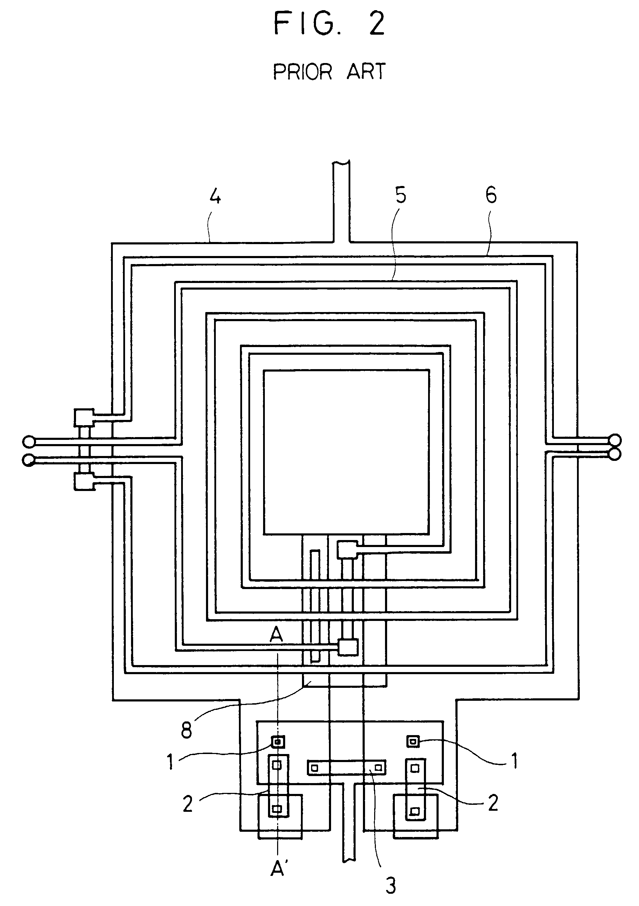

Fig. 2 is a top plan view showing the prior art DC SQUID;
Fig. 3 is a sectional view showing a fabrication example of a DC SQUID;
Fig. 4 is a top plan view of a DC SQUID with double washer coils connected in parallel; and
Fig. 5 is a top plan view of a DC SQUID with double washer coils connected in series.

### Detailed description of the preferred embodiments

The present invention will be described in the following in connection with the embodiments thereof with reference to the accompanying drawings.

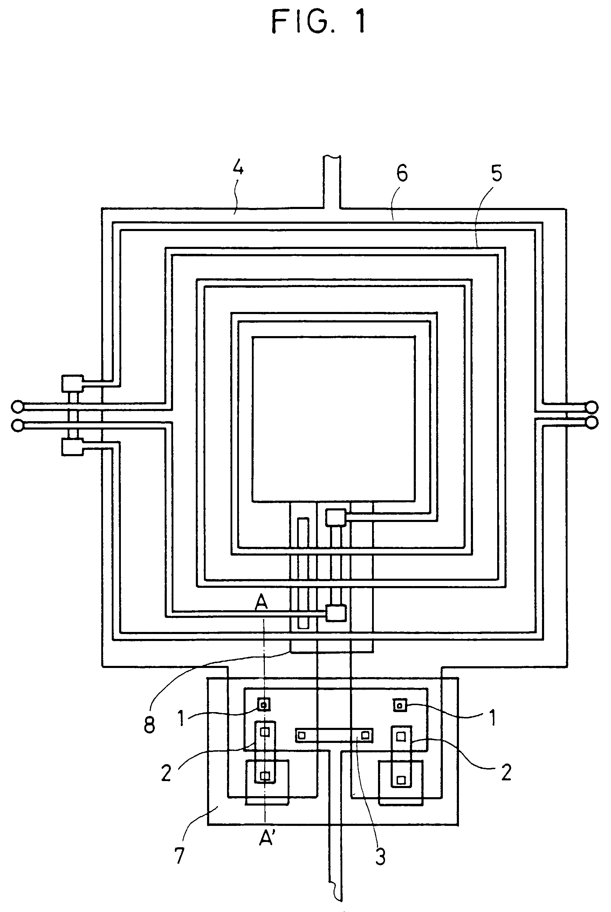

Fig. 1 is a top plan view showing a DC SQUID as a first embodiment of the present invention.

The DC SQUID operation becomes unstable in the manner that output signals flicker in its superconductivity state operation because magnetic flux becomes trapped or shifted. Such flicker becomes bigger in effect, especially in the case of trapping in the neighborhood of the Josephson device 1. In such a structure the ground plane 7, which is an electrically insulated superconductive layer, covers broadly enough the area with the Josephson devices. Thus the traps of magnetic flux will hardly be generated, and the behavior becomes stable. In the production of the ground plane 7, the number of processing steps does not have to be increased, because the ground plane 7, which is a superconductive layer, can be simultaneously formed in the same processing step as the washer cover 8.

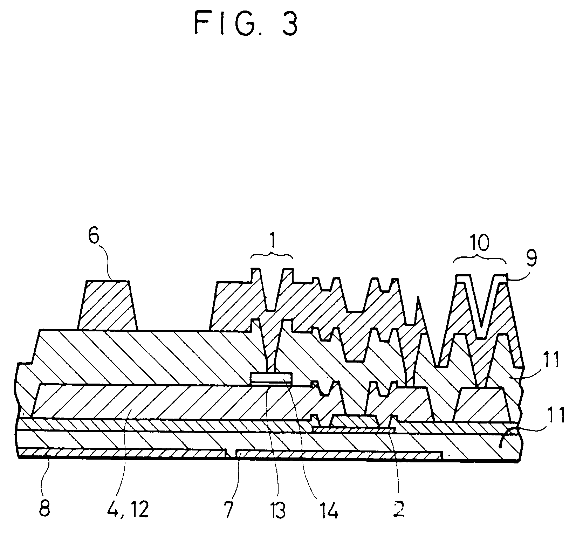

With reference to the accompanying drawing Fig. 3, which shows a cross section along the line A - A' in Fig. 1, a manufacturing process in practice will be described in the following. Concerning the manufacture thereof, a thin film photolithography patterning method should be applied, that is ground plane 7 and washer cover 8 are formed with superconductive film in the first phase, and insulated by inter-layer insulating film 11. As for an example of superconductive film, usually Nb is deposited by DC magnetron sputtering. The foresaid film should be as thick as the superconductive shielding, therefore, about 100 nm or more will be enough in case of Nb. The ground plane 7 may also be electrically grounded to the SQUID.

Next, after resistance films of the shunting resistor 2 and the dumping resistor 3 are deposited in the DC SQUID, the resistor films are insulated by means of an inter-layer insulating film 11, and the value of resistance should be fixed to a predetermined level. Said resistance film can be made of a metal such as Mo, MoN, Pd, Au, Cu, Al, Pd, Ti etc., any of which can be deposited by sputtering or evaporation.

Here, a 100 nm layer of Al should be deposited by DC magnetron sputtering and the pattern is then formed to the designed size by photolithography. For the purpose of etching the Al layer, both wet and dry etching methods can be used. As for an example of using wet etching, there exists a method using a mixture of mainly phosphoric acid and nitric acid. As for an example of using dry etching, there exists a method of reactive ion etching (RIE) using a chloride gas such as CCl₄ or a mixture gas of the chloride gas. Here, Al is etched by a wet etching method. The inter-layer insulating film 11 can be made of SiO₂, SiO, Si, MgO and the like. Any of these materials can be deposited by sputtering, evaporation or CVD and so on. The deposited film is set to be 1.5 to 2 times as thick as the resistance film, so as to insulate the resistance film completely.

After a 100 to 200 nm thick SiO₂ layer is deposited by RF magnetron sputtering, the SiO₂ is etched to form contact holes to the resistance film by the photolithographic step. Both the wet and dry etching methods can be used for the etching of the SiO₂. Wet etching is examplified by a method using a mixture of hydrofluoric acid. Dry etching is exemplified by reactive ion etching (i.e. RIE) using a mixture of CF₄ or CHF₃, and oxygen. Here, the SiO₂ is etched by the RIE method using a mixture of CHF₃ and oxygen.

The next step will be forming a Josephson device 1 comprising a lower electrode 12, a barrier layer 13, and an upper electrode 14, each of which should be deposited. The electrode 14 and the barrier layer 13 are etched by photolithography. The Josephson device 1 can be exemplified not only by the Nb/AlOx/Nb structure but also by a variety of structures of NbN/Mgo/NbN, Nb/Si/Nb, Nb/Nb-oxide/Nb and the like. Here, the Nb/AlOx/Nb structure is deposited by a sputtering process. Examples of the deposition here are as follows.

Ar gas is introduced into a reaction chamber, which is evacuated to a high vacuum of 10⁻⁵ Pa or less. And the Nb film of the lower electrode 12 is deposited under a pressure of 0.1 to 4 Pa by DC magnetron sputtering. The film is deposited to set to 100 to 300 nm in thickness. Then, the introduction of the argon gas is interrupted, and the reaction chamber is evacuated again to a high vacuum of 10⁻⁵ Pa or less. After this, the argon gas is introduced so that the Al is deposited to 1 to 20 nm under a pressure of 0.1 to 4 Pa by DC magnetron sputtering. If the Al sputtering pressure is lower than that of Nb, the film becomes finer and this uniformity will be increased on the Nb surface.

No problem arises here, even though the evacuation to a high vacuum is not elaborately performed before the sputtering of the Al. The reaction chamber is evacuated to a high vacuum of 10⁻⁵ Pa or less, and oxygen or a gas mixture of oxygen and argon is introduced to adjust the pressure to the set level. Then, the Al surface is oxidized to form the barrier layer 13 of AlOx/Al. The reaction chamber is evacuated to a high vacuum of 10⁻⁵ Pa or less, and the upper electrode 14 is deposited to 100 to 300 nm under the aforementioned Nb depositing condition.

Next, the upper electrode 14 and the barrier layer 13 are etched by a photolithographic step to form the Josephson device 1. The etching method used is generally a dry etching method using a plasma. The Nb of the upper electrode 14 is subjected to reactive ion etching (RIE) using CF₄ or a gas mixture of CF₄ and oxygen. The Al of the barrier layer 13 is removed by either the wet etching method using an acid or the RIE using Ar gas. Here, the barrier layer 13 need not neccessarily be etched.

Next, the washer coil 4 is formed by patterning the superconductive film deposited as the lower electrode 12 of the Josephson device 1 by the photolithography. The etching method used is generally a dry etching method using plasma. The Nb of the lower electrode 12 is subjected to the plasma etching or reactive ion etching (RIE) using a gas mixture of CF₄ and oxygen. Here, the etching is so different from that of the aforementioned upper electrode 14 that isotropic etching is effected by increasing the amount of oxygen and that the resist film in the peripheral of the pattern is etched with oxygen into a tapered shape. The etching can be specifically exemplified by using a plasma etching apparatus with gas, which is prepared by adding 10 % of oxygen to CF₄, under a pressure of 133 Pa and with a power of 50 W.

Next, after the inter-layer insulating film 11 is deposited, a contact hole is then formed by photolithography. And a superconductive film is then deposited again to form a feedback modulation coil 6 and an input coil 5 by photolithography. The superconducting film is exemplified by Nb, NbN, Pb-In or Pb-In-Au which is deposited by sputtering or evaporation.

Here, Nb film is deposited to 250 - 600 nm by DC magnetron sputtering, just as the Josephson junction electrode is formed. Before this deposition, the substrate should be reversely sputtered using Ar gas so that the substrate forms a superconductive contact. Next, the washer coil 4 and counter electrodes and other wirings are formed by photolithography. The etching of the above is by plasma etching like the forming of the aforementioned lower electrode 12.

In the case that the detection coil which detects the external magnetic field is not formed simultaneously with the process of forming the SQUID, it is necessary that the external detection coil should be superconductively connected to the SQUID for measuring purposes. For this purpose, the buffer metal 9 may be necessary for the superconductive contact on the pad 10. In the case that Pb-In alloy wire is used for the superconductive contact on the pad 10 by Nb, a 10 - 100 nm thick Au layer is deposited on the buffer metal by sputtering. The patterning for the above can be done easily by wet etching using acid and the like.

For the exfoliation of resist in the photolithographic process, either a wet or a dry method can be applied. In the wet method, an organic solvent such as acetone and the like, alkaline detachment liquid, concentrated nitric acid, heated concentrated sulfuric acid, etc. is used. In the dry method, oxygen plasma or UV rays are used. Exfoliation can be done by the combination of one or both methods or one or several of the materials above.

The fabrication of a DC SQUID according to the present invention can be done as mentioned above. The sequence of layer forming can be interchanged or converted, as long as the circuitry is not changed. Table 1 shows an example of a set of design parameters for the fabrication of a SQUID, the shape of which is shown in Fig. 1, i.e. the first embodiment.

**Table 1**

| | |
|---|---|
| washer hole size | 50 µm |
| washer inductance | 79 pH |
| input coil inductance | 64nH |
| input coil turns | 27 |
| feedback modulation coil turns | 1 |
| Josephson junction size | 5 µm |
| Josephson junction critical current | 16 µA |
| shunting resistor | 4 Ω |
| damping resistor | 2 Ω |

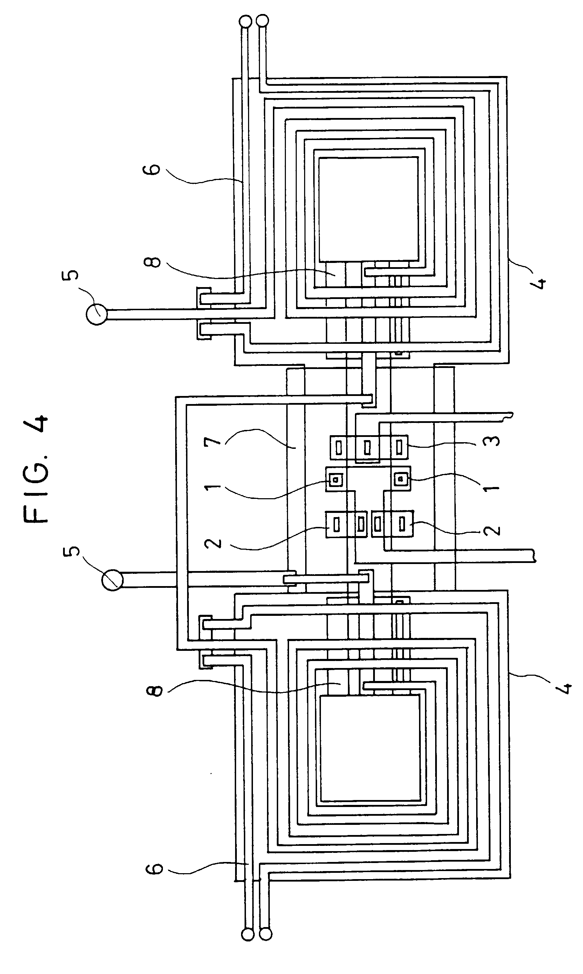

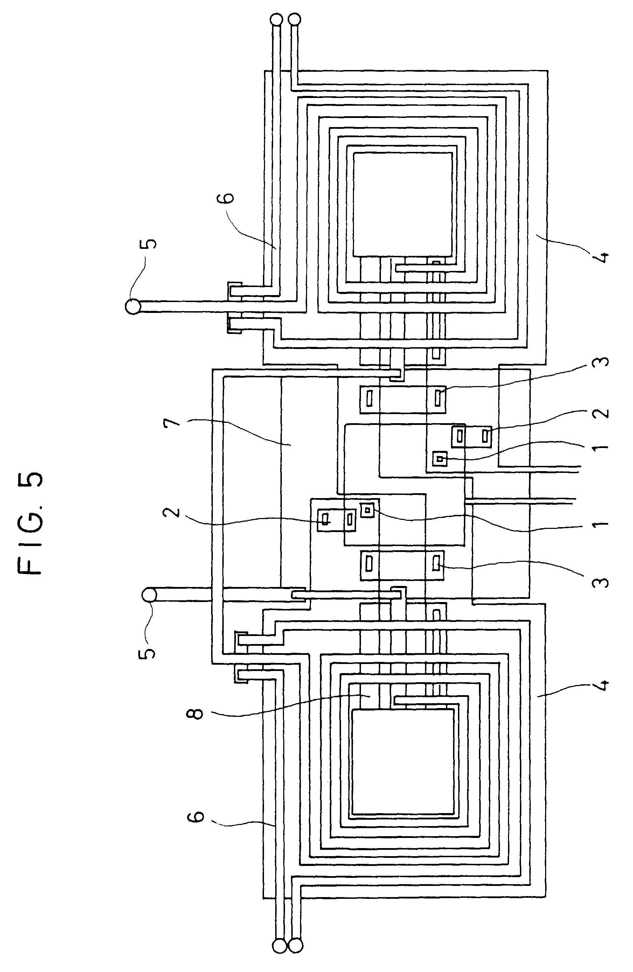

So far, the single washer coil type with a single washer coil has been exemplified. Multiple washer coil types, the circuitry of which is the same as that of the first embodiment, but in which multiple washer coils are jointed, can also be fabricated into SQUIDs. Fig. 4 and Fig. 5 show examples of second and third embodiments with samples of double washer coil types with two washer coils.

In a DC SQUID with a single washer coil as shown in Fig 1, the first embodiment, the output signals tend to flicker, since it detects even uniform magnetic fields of flux linkage which the washer coil links to. Since SQUIDs with two washer coils can cancel the uniform magnetic flux of each other, the flicker of their output signals becomes smaller, and their operation becomes more stable.

Two ways of connecting two washer coils are possible, namely in parallel or in series. Fig. 4 is an example of parallel connecting and Fig. 5 is an example of serial connecting. Each double washer coil SQUID has two feedback modulation coils 6, and each such SQUID can be utilized in many different ways. For feedback modulation purposes, either one coil or both coils can be used. Two coils may be used in such a way that one is for feedback purposes and another for modulation purposes. And another usage can be in that two coils are used only for modulation purposes, and in this case, the feedback function may be realized through the usage of a coupled detection coil which works not only for detection but also for feedback.

According to the present invention as hereinabove shown, trapping of magnetic flux will hardly be generated, the flicker of outputs owing to magnetic flux trapping can be reduced, and then a stable operation of the SQUID can be realized, by setting up and overlaying the ground plane on the DC SQUID Josephson device.

## Claims

1. A DC superconducting quantum interference device comprising:
a Josephson device (1) coupled to both ends of a washer coil (4) forming a superconducting ring;
a shunt resistor (2) connected in parallel to said Josephson device (1);
a damping resistor (3) coupled to both ends of said washer coil (4);
an input coil (5) and a feedback modulation coil (6), both of which are magnetically coupled to said washer coil (4); and
a washer cover (8) which is situated at the bottom of the SQUID, which is disposed to cover only a slit portion of said washer coil (4) and which is formed of a superconducting film;
**characterized in**
that a ground plane (7) is formed of a superconducting film and disposed to cover an area of said Josephson device (1) without covering said washer coil (4) for shielding said Josephson device (1) from magnetic noise without reducing the sensitivity of the Josephson device (1) to an external magnetic field;
wherein said ground plane (7) and said washer cover (8) are formed in the same layer.

2. A DC superconducting quantum interference device according to claim 1, wherein said input coil (5) is multiplically formed in spiral shape upon said washer coil (4).

## Patentansprüche

1. Ein Gleichstrom supraleitendes Quanteninterferenz-Bauelement, enthaltend:
eine Josephson-Vorrichtung (1), die an beide Enden einer Scheibenspule (4) gekoppelt ist, die einen supraleitenden Ring bildet;
ein Nebenanschlußwiderstand (2), der in Parallelschaltung an die Josephson-Vorrichtung (1) angeschlossen ist;
ein Dämpfungswiderstand (3), der an beide Enden der Scheibenspule (4) angekoppelt ist;
eine Eingangsspule (5) und eine Rückkopplungs-Modulationsspule (6), die beide magnetisch mit der Scheibenspule (4) gekoppelt sind; und
eine Scheibenüberdeckung (8), die am Boden des SQUID angeordnet ist, der so eingerichtet ist, daß er nur einen Schlitzteil der Scheibenspule (4) abdeckt, und der aus einer supraleitenden Schicht besteht;
dadurch gekennzeichnet, daß
eine Horizontalebene (7) aus einer supraleitenden Schicht gebildet ist und so angeordnet ist, daß sie einen Bereich der Josephson-Vorrichtung (1) abdeckt ohne die Scheibenspule (4) zum Abschirmen der Josephson-Vorrichtung (1) gegen magnetische Störungen abzudecken, ohne die Empfindlichkeit der Josephson-Vorrichtung (1) gegen ein externes Magnetfeld zu reduzieren; und
in dem die Horizontalebene (7) und die Scheibenüberdeckung (8) in der gleichen Schicht ausgebildet sind.

2. Ein Gleichstrom supraleitendes Quanteninterferenz-Bauelement gemäß Anspruch 1, in dem die Eingangsspule (5) in Spiralform auf der Scheibenspule (4) mehrfach ausgebildet ist.

## Revendications

1. Dispositif supraconducteur à interférence quantique en courant continu comprenant :
un dispositif à effet Josephson (1) couplé aux deux extrémités d'une bobine en forme de rondelle (4) formant un anneau supraconducteur,
une résistance de dérivation (2) reliée en parallèle audit dispositif à effet Josephson (1),
une résistance d'amortissement (3) couplée aux deux extrémités de ladite bobine en forme de rondelle (4),
une bobine d'entrée (5) et une bobine de modulation de contre-réaction (6), toutes deux étant couplées magnétiquement à ladite bobine en forme de rondelle (4), et
une coiffe en forme de rondelle (8) qui est placée au fond du dispositif supraconducteur à interférence quantique en courant continu (SQUID), qui est disposée pour ne recouvrir qu'une partie de fente de ladite bobine en forme de rondelle (4), et qui est formée d'un film supraconducteur,
caractérisé en ce que
un plan de masse (7) est formé d'un film supraconducteur et est disposé pour recouvrir une zone dudit dispositif à effet Josephson (1) sans recouvrir ladite bobine en forme de rondelle (4) afin de blinder ledit dispositif à effet Josephson (1) vis à vis du bruit magnétique sans réduire la sensibilité du dispositif à effet Josephson (1) vis à vis d'un champ magnétique extérieur,
dans lequel ledit plan de masse (7) et ladite coiffe en forme de rondelle (8) sont formés dans la même couche.

2. Dispositif supraconducteur à interférence quantique en courant continu selon la revendication 1, dans lequel ladite bobine d'entrée (5) est réalisée de façon multiple en forme de spirale sur ladite bobine en forme de rondelle (4).
